# EUROPEAN PATENT SPECIFICATION

(11) **EP 0 875 077 B1**
(45) Date of publication and mention of the grant of the patent: **17.09.2003**
(21) Application number: 97901298.6
(22) Date of filing: 17.01.1997
(51) Int. Cl.: H01L 29/12, H01L 29/45, H01L 21/28

(54) **A SEMICONDUCTOR DEVICE WITH A LOW RESISTANCE OHMIC CONTACT BETWEEN A METAL LAYER AND A SiC-LAYER**
HALBLEITERANORDNUNG MIT EINEM OHMISCHEN KONTAKT MIT NIEDRIGEM WIDERSTAND ZWISCHEN EINE METALLSCHICHT UND EINE SIC-SCHICHT
DISPOSITIF SEMICONDUCTEUR AYANT UN CONTACT OHMIQUE DE FAIBLE RESISTANCE ENTRE UNE COUCHE DE METAL ET UNE COUCHE DE SiC

(30) Priority: 19.01.1996 SE 9600199
(43) Date of publication of application: 04.11.1998
(73) Proprietor: ABB RESEARCH LTD., 8050 Zürich (CH)
(72) Inventor: HARRIS, Christopher, S-191 72 Sollentuna (SE)
(74) Representative: Olsson, Jan
(86) International application number: SE9700062
(87) International publication number: WO97026678

(56) References cited:
- EP-A- 0 458 353
- EP-B- 0 249 777
- US-A- 4 985 742
- US-A- 5 273 933

## Description

### Technical field of the invention and prior art

The present invention relates to a semiconductor device comprising a semiconductor layer of SiC, a metal layer adapted to form a low resistance ohmic contact with the SiC-layer and a thin layer of a material having a smaller band gap than the SiC of the SiC-layer and placed between the SiC-layer and the metal layer, said SiC-layer being at least in the region next to said thin layer highly doped.

All types of semiconductor devices in which a contact between a metal layer and a SiC-layer is to be formed are comprised, such as for example different types of diodes, transistors and thyristors. Due to the characteristics of SiC such devices are often high power devices.

SiC is a semiconductor material having a large band gap, the magnitude of which is between 2,3 and 3,3 eV dependent on the polytype in question, i.e. the gap between the valence band and the conduction band. For this reason SiC has, in common with other wide band gap semiconductors, the problem that it is extremely difficult to form low resistance ohmic contacts on SiC. One reason for this difficulty is the large difference between the work function of the metal of such a metal layer and the electron affinity of the semiconductor, which results in a large Schottky-barrier height. It has been tried to solve this problem by making a heterojunction contact, whereby a material having a lower band gap is grown as an intermediate layer between the metal layer and the wide band gap semiconductor as defined above and as described in U.S. patent 3 984 261. Accordingly, the definition "a metal layer adapted to form a low resistance ohmic contact with the SiC-layer" is to be interpreted broadly and it expresses that there shall be formed a low resistance ohmic contact between a metal layer and a SiC-layer, but this may be done by interposing a thin layer of another material.

The European patent B1 O 249 777 describes how such a heterojunction is used for obtaining a low resistance ohmic contact between a semiconductor material and a metal layer, but the semiconductor is not SiC, but a III-V-material, for instance GaP, which has a considerably lower band gap than SiC.

A known semiconductor device according to the introduction has been suggested (V.A. Dimitriev, K. Irvine, M. Spencer and G. Kelner Appl. Phys. Lett. vol. 64(3) p. 318 (1994)) for 6H SiC, while using the polytype 3C SiC as an intermediate layer, but the disadvantage of this is that the polytype 3C is still a relatively wide band gap material and the contact problem is thus not solved.

Another problem of different materials used so far as intermediate layers in such heterojunctions and also as semiconductors making a direct contact with a metal layer is that the Fermi-level of these materials is pinned as a result of a high density of traps within the band gap of the semiconductor. Typically pinning is due to deep states (traps) and therefore the Fermi-level resides close to the centre of the band gap of the material. These states are for example formed by the deposition of the metal. The pinning is for a narrow region only, in this case the interface between the metal layer and the semiconductor, so that the Fermi-level is not "pinned" in the bulk of the semiconductor. Pinning is defined as the phenomena such that the Fermi-energy of the semiconductor is in this single location, i.e. at said interface, fixed at a single energy (the trap energy) independent of the doping condition in the semiconductor. This effect is typically seen between a metal and a semiconductor, for example the III-V compounds, such as GaAs, and results in a large barrier height. It is not observed at the heterojunction between semiconductors provided the interface is of good quality, i.e. of low trap density, and it would accordingly not be present between the SiC-layer and said thin layer in the device defined in the introduction. Normally, it is desired that the work function of the metal in question is matched with the electron affinity of the semiconductor for making a low resistance ohmic contact, but due to said pinning the midgap states in the semiconductor will determine the height of the Schottky-barrier independent of the work function of the metal. This "pinning" phenomena is also there in the semiconductor device according to the European patent B1 0 249 777, but this phenomena is of minor importance, since the band gap of the semiconductors used there is very narrow.

A prior art example disclosing a group 3B-nitride layer on SiC according to the preamble of claim 1 is know from US-A-4 985 742. EP-A-0 458 352 discloses a group 3B-nitride layer for ohmic contacts on BN.

### Summary of the invention

The object of the present invention is to provide a semiconductor device according to the introduction, which has an excellent low resistance ohmic contact between the SiC-layer and the metal layer.

This object is in accordance with the invention obtained by making said thin layer of a Group 3B-nitride.

Thus, it has been realised that Group 3B-nitrides do not have pinned (fixed) Fermi-levels at the interface with a metal, which means that the work function of the metal will determine the Schottky-barrier height, so that it will be possible to choose a suitable metal for a low barrier. Thus, it is possible to form a low resistance ohmic contact between the SiC-layer and a metal layer by choosing a Group 3B-nitride having a smaller bandgap than the SiC of the SiC-layer as a thin layer between the metal layer and the SiC layer. Thanks to the fact that the SiC-layer is highly doped at least in the region next to said thin layer the thin layer may be undoped, since there will due to "modulation doping" be a transfer of charge from the SiC layer having a large band gap to the thin layer having a narrower band gap, so that the narrow band gap material has an excess of charge in the conduction band thereof and will in fact behave as a metal, so that a low resistance ohmic contact may be established without any doping in advance of said thin layer. This means that it will be easier to grow said thin layer of a high quality. Furthermore, it is important that the heterojunction of the device has a high quality so as to avoid traps, i.e. mid gap states, there, and this is obtained thanks to the comparatively good lattice match of the Group 3B-nitrides with SiC.

According to a preferred embodiment of the invention said Group 3B-nitride comprises a content of indium and at least another Group 3B-element. Indium is a suitable element for making the band gap of the Group 3B-nitride narrower than that of SiC of any polytype, so that it is very advantageous to have such content in said Group 3B-nitride. However, it is for the ease of the growth of a high quality thin layer of importance that it also contains at least another Group 3B-element besides indium.

According to another preferred embodiment of the invention said Group 3B-nitride has a content of at least indium and gallium. GaN has a larger band gap than SiC, but it may be easily grown on SiC and thanks to the addition of indium the band gap is made narrower, so that said Group 3B-nitride may be suited for forming a low resistance ohmic contact aimed at.

According to another preferred embodiment of the invention said Group 3B-nitride is Ga₁₋ₓInₓN. Such a material for said thin layer has been found to be easy to grow on SiC, have a smaller band gap than SiC and have a not pinned Fermi-level at the interface with a metal.

According to a very preferred embodiment of the invention the indium content of the Group 3B-nitride is adjusted to the metal chosen for matching the electron affinity of said material with the work function of the metal of said metal layer. Thus, the indium content is a parameter easy to handle to adjust the electron affinity of the Group 38-nitride for matching the work function of the metal of said metal layer for reducing the barrier height of said ohmic contact between the metal layer and said thin layer.

According to a still further, also very preferred embodiment of the invention the indium content of said Group 3B-nitride is adjusted according to the type of doping, p or n, of said SiC-layer. In this way the indium content will be a parameter to adjust the band-alingement according to whether you want a p- or n-type contact. The other Group 3B-element of said Group 3B-nitride may namely have a gap between the conduction band and the valence band which is not centered with respect to the band gap of the SiC of said SiC-layer, so that different concentrations of indium in said Group 3B-nitride may be appropriate depending on the type of doping of the SiC-layer close to the interface to said thin layer. For instance, it is believed that GaN has a band gap centre being displaced with respect to the band gap centre of Sic, which means that different indium-contents may be needed for p- and n-doped SiC-layers.

According to another preferred embodiment of the invention said thin layer is undoped. The advantages thereof has already been presented above, and the possibility to make this layer undoped is provided by the fact that a modulation doping process takes place thanks to the high doping of the SiC next to said thin layer, the smaller band gap of the thin layer and the fact that the layer really is thin.

Further advantages and preferred features of the invention will appear from the following description and the other dependent claims.

### Brief description of the drawings .

With reference to the appended drawings, below follows a specific description of a preferred embodiment of the invention cited as an example.

In the drawings:
- Fig. 1: is a view illustrating how the extension of the conduction band and the valence band would be in a semiconductor device of the invention from a SiC-layer, a thin Group 3B-nitride layer and a metal layer at a contact of said device if the different layers would not have any influence on each other, and
- Fig. 2: is a view corresponding to Fig. 1 but illustrating the real extension of said conduction and valence bands at said contact of the semiconductor device.

### Detailed description of a preferred embodiment of the invention

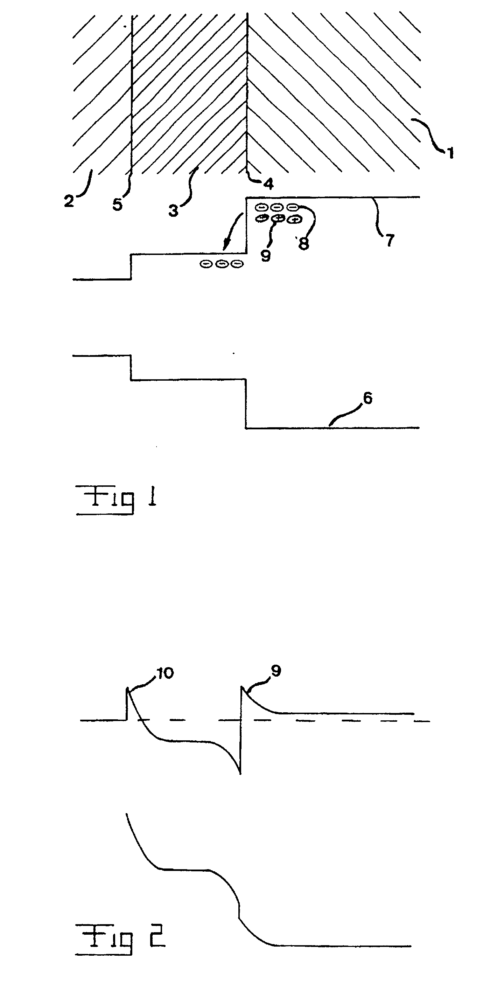

Fig. 1 illustrates a low resistance ohmic contact between a SiC-layer 1 and a metal layer 2 with an intermediate thin layer 3 of a Group 3B-nitride in a semiconductor device. The SiC-layer is a mono-crystalline layer of SiC of any polytype. The Group 3B-nitride is in the present case Ga₁₋ₓInₓN, in which x is chosen to obtain a smaller bandgap of the Group 3B-nitride than the SiC of the SiC-layer 1 and for obtaining an electron affinity of the Group 3B-nitride matching the work function of the metal selected for said metal layer. The semiconductor device in question may be of any type, such as an IGBT, a GTO and a rectifying diode.

In this way two junctions are formed, a first heterojunction 4 between the SiC-layer 1 and said thin layer 3 and a second junction 5 between the thin layer and the metal layer. The SiC-layer 1 is highly doped with donors at least close to the heterojunction 4, but it would also be possible to highly dope it with acceptors. Highly doped does here mean that the concentration of dopants exceeds 10¹⁷, preferably exceeding 10¹⁸ cm⁻³. It is very schematically illustrated that the energy gap between the valence band 6 and the conduction band 7 is larger in the SiC layer 1 than in said thin layer 3. In this way a band-offset is obtained at said heterojunction 4. Since the SiC-layer is highly doped with donors these have their extra electrons 8 at a higher energy level than the conduction band level at the other side of the heterojunction, which will result in a fall of said electrons as indicated by the arrow to the lower energy level in said thin layer 3 while ionising said donors and leaving a positive charge 9 in the SiC-layer 1. This technique of providing only the layer with the largest band gap with impurities is called selective doping or modulation doping. In this way an electrical field is created at the heterojunction bending the conduction bands in the way shown in Fig. 2. The higher the concentration of donors in the first layer comparatively close to the heterojunction the sharper will the conduction band be bent. Thanks to the high concentration of dopants in the SiC-layer a very narrow barrier 9 will in this way be established between the SiC-layer and said thin layer 3, so that electrons may easily tunnel through this barrier and the resistance of this heterojunction will be neglectable.

The thin layer 3 may be undoped, since the conduction band thereof will in this way by the modulation doping process be filled with electrons, so that this thin layer will act as a metal and have a very low resistance. It would however also be possible to dope the thin layer 3 with the dopant type corresponding to that of the SiC-layer, thus in the case shown in the figures with donors. The layer 3 has to be thin for obtaining this metal behaviour thereof, and thin will in this embodiment mean a thickness below 300Å and in some applications below 100Å. The thin layer 3 is preferably mono-crystalline, but it may also be poly-crystalline and still work depending on the influence of the grain boundary.

The Fermi-levels of the different layers have, as known, to be at the same level, which will result in an extension of the conduction band and the valence band in accordance with Fig. 2. It has been found that the Fermi-level of a Group 3B-nitride is not pinned, i.e. fixed, at the interface to a metal, which means that there are relatively few mid gap states (traps) at said interface, which would change the position of the Fermi-level of said thin layer there, so that the barrier 10 then would be much higher. Accordingly, a low resistance ohmic contact between a SiC-layer and a metal layer may be achieved by selecting a Group 3B-nitride as a material for a thin layer between the SiC-layer and the metal layer.

As already mentioned above the mole fraction of In incorporated in said thin layer 3 can be varied to tune the band offset with respect to both the SiC-layer 1 and the metal layer 2. The higher the content of In in the Group 3B-nitride the smaller will the band gap thereof be. GaN has a band gap being slightly larger than most polytypes of SiC and a content of indium therein will reduce this band gap. The band gap of GaN is not centered with respect to the band gap of SiC, so that it will be suitable to choose different concentrations of indium in said Group 3B-nitride according to the type of doping, p or n, of the SiC-layer. Thus, the indium content may vary according to certain considerations, and it will typically be between 5 and 20% of the N content.

A contact of this type may be easily produced by forming the highly doped SiC-layer 1 either by epitaxial growth (CVD, MBE etc.) or by ion implantation. The Group 3B-nitride layer 3 should be of high quality single crystal and should again be grown using an epitaxial technique (CVD, MBE, magnetron sputtering, etc.). Following the deposition of the Group 3B-nitride a metal layer 2 should be deposited by any of the available techniques, said metal being chosen to give a good contact to the Group 3B-nitride. Finally, the layers are patterned using lithography to cover only those areas where a contact is required. The annealing temperature should be low, which means below 1000°C, but in most cases it may be considerably lower. The possibility to not dope said thin layer but nevertheless obtain a low resistance ohmic contact simplifies the production of this contact.

The invention is of course not in any way restricted to the preferred embodiments described above, but many possibilities to modifications thereof will be apparent to a man with ordinary skill in the art.

All definitions concerning the materials of the different device layers do of course include inevitable impurities as well as intentional doping of the layers in question.

The definition layer is to be interpreted broadly and comprises all types of volume extensions and shapes.

Other Group 3B-nitrides than GaInN are also conceivable, such as AlInN, in which case the In-content has to be comparatively high, since AlN has a much higher bandgap than SiC.

The SiC-layer may be of any polytype of SiC, such as for example 6H, 4H, 3C and 15R.

## Claims

1. A semiconductor device comprising a semiconductor layer (1) of SiC, a metal layer (2) adapted to form a low resistance ohmic contact with the SiC-layer and a thin layer (3) placed between the SiC-layer and the metal layer, said SiC-layer being at least in the region next to said thin layer highly doped, wherein the material of said thin layer is a Group 3B-nitride, **characterized in that** said thin layer is of a material having a smaller bandgap than the SiC of the Sic-layer.

2. A device according to claim 1, **characterized in that** said Group 3B-nitride comprises a content of indium and at least another Group 3B-element.

3. A device according to claim 2, **characterized in that** said Group 3B-nitride has a content of at least indium and gallium.

4. A device according to claim 3, **characterized in that** said Group 3B-nitride is Ga₁₋ₓInₓN.

5. A device according to any of claims 2-4, **characterized in that** the indium content of the Group 3B-nitride is adjusted to the metal chosen for matching the electron affinity of said material with the work function of the metal of said metal layer.

6. A device according to any of claims 2-4, **characterized in that** the indium content of said Group 3B-nitride is adjusted according to the type of doping, p or n, of said SiC-layer (1).

7. A device according to any of claims 1-6, **characterized in that** said thin layer (3) is undoped.

8. A device according to any of claims 1-7, **characterized in that** said thin layer (3) has a thickness below 300 Å.

9. A device according to any of claims 1-8, **characterized in that** said thin layer (3) is a mono-crystalline layer.

10. A device according to any of claims 1-9, **characterized in that** highly doped means a concentration of dopants exceeding 10¹⁸ cm⁻³.

## Patentansprüche

1. Halbleitervorrichtoung mit einer Halbleiterschicht (1) aus SiC, einer Metallschicht (2), die ausgebildet ist, um einen ohmschen Kontakt mit niedrigem Widerstand mit der SiC-Schicht zu bilden, und einer dünnen Schicht (3), die zwischen der SiC-Schicht und der Metallschicht angeordnet ist, wobei die SiC-Schicht mindestens in dem Bereich neben der dünnen Schicht hoch dotiert ist, wobei das Material der dünnen Schicht ein Nitrid der Gruppe 3B ist,
**dadurch gekennzeichnet, dass**
die dünne Schicht aus einem Material besteht, das eine kleinere Bändlücke als das SiC der SiC-Schicht aufweist

2. Vorrichtung nach Anspruch 1,
**dadurch gekennzeichnet, dass**
das Nitrid der Gruppe 3B einen Gehalt von Indium und mindestens einem weiteren Element der Gruppe 3B urnfasst

3. Vorrichtung nach Anspruch 2,
**dadurch gekennzeichnet, dass**
das Nitrid der Gruppe 3B einen Gehalt von zumindest Indium und Gallium aufweist.

4. Vorrichtung nach Anspruch 3,
**dadurch gekennzeichnet, dass**
das Nitrid der Gruppe 3B Ga₁₋ₓInₓN ist

5. Vorrichtung nach einem der Ansprüche 2 bis 4,
**dadurch gekennzeichnet,dass**
der Indiumgehalt des Nitrids der Gruppe 3B auf das Metall eingestellt ist, das zur Anpassung der Elektronenaffinität des Materials an die Austrittsarbeit des Metalls der Metallschicht gewählt ist.

6. Vorrichtung nach einem der Ansprüche 2 bis 4,
**dadurch gekennzeichnet, dass**
der Indiumgehalt des Nitrids der Gruppe 3B gemäß der Dotierungsart, p oder n, der SiC-Schicht (1) eingestellt ist

7. , Vorrichtung nach einem der Ansprüche 1 bis 6,
**dadurch gekennzeichnet, dass**
die dünne Schicht (3) undotiert ist.

8. Vorrichtung nach einem der Ansprüche 1 bis 7,
**dadurch gekennzeichnet, dass**
die dünne Schicht (3) eine Dicke von unter 300 Å aufweist

9. Vorrichtung nach einem der Ansprüche 1 bis 8,
**dadurch gekennzeichnet, dass**
die dünne Schicht (3) eine monokristalline Schicht ist

10. Vorrichtung nach einem der Ansprüche 1 bis 9,
**dadurch gekennzeichnet, dass**
hoch dotiert eine Konzentration von Dotiermitteln bedeutet, die 10¹⁸ cm⁻³ übersteigt.

## Revendications

1. Dispositif à semiconducteur comprenant une couche (1 ) semiconductrice en SiC une couche (2) métallique apte à former un contact ohmique de petite résistance avec la couche de SiC et une couche (3) mince, la couche de SiC étant au moins dans la région proche de la couche mince très dopée dans lequel la matière de la couche mince est un nitrure du groupe 3B, **caractérisé en ce que** la couche mince est en une matière ayant une bande interdite plus petite que celle du SiC de la couche de SiC

2. Dispositif suivant la revendication 1, **caractérisé en ce que** le nitrure du groupe 3B a une teneur en indium et en au moins un autre élément du groupe 3B.

3. Dispositif suivant la revendication 2, **caractérisé en ce que** le nitrure du groupe 3B a au moins une teneur en indium et en gallium.

4. Dispositif suivant la revendication 3, **caractérisé en ce que** le nitrure du groupe 3B est Ga₁₋ₓ InₓN.

5. Dispositif suivant l'une quelconque des revendications 2 à 4, **caractérisé en ce que** la teneur en indium du nitrure du groupe 3B est ajustée en fonction du métal choisi pour adapter l'affinité électronique de la matière à la fonction de travail du métal de la couche métallique.

6. Dispositif suivant l'une quelconque des revendications 2 à 4, **caractérisé en ce que** la teneur en indium du nitrure du groupe 3B est ajustée en fonction du type de dopage, p ou n, de la couche (1 ) de SiC

7. Dispositif suivant l'une quelconque des revendications 1 à 6, **caractérisé en ce que** la mince couche (3) n'est pas dopée.

8. Dispositif suivant l'une quelconque des revendications 1 à 7, **caractérisé en ce que** la mince couche (3) a une épaisseur inférieure à 300 angstroems.

9. Dispositif suivant l'une quelconque des revendications 1 à 8, **caractérisé en ce que** la mince couche (3) est une couche monocristalline.

10. Dispositif suivant l'une quelconque des revendications 1à 9, **caractérisé en ce que** très dopé signifie une concentration d'agents de dopage dépassant 10¹⁸ cm⁻³.
